(19) Europäisches Patentamt

European Patent Office

Office européen des brevets

(11) Numéro de publication: **0 187 584**
**B1**

(12) **FASCICULE DE BREVET EUROPEEN**

(45) Date de publication du fascicule du brevet:
**16.05.90**

(21) Numéro de dépôt: **85402456.9**

(22) Date de dépôt: **10.12.85**

(51) Int. Cl.⁵: **H03K 19/21**

(54) **Porte logique à coïncidence, et circuits logiques séquentiels mettant en oeuvre cette porte à coïncidence.**

(30) Priorité: **14.12.84 FR 8419194**

(43) Date de publication de la demande:
**16.07.86 Bulletin 86/29**

(45) Mention de la délivrance du brevet:
**16.05.90 Bulletin 90/20**

(84) Etats contractants désignés:
**DE GB NL**

(56) Documents cités:
**FR-A- 2 410 914**

(73) Titulaire: **THOMSON-CSF, 51, Esplanade du Général de Gaulle, F-92800 Puteaux(FR)**

(72) Inventeur: **Pham, Ngu Tung, THOMSON-CSF SCPI 173, bld. Haussmann, F-75379 Paris Cedex 08(FR)**

(74) Mandataire: **Taboureau, James et al, THOMSON-CSF SCPI, F-92045 Paris La Défense Cédex 67(FR)**

**Description**

La présente invention concerne les circuits logiques séquentiels rapides, et plus particulièrement les portes logiques à coïncidence à deux entrées. Elle met en œuvre soit des transistors à effet de champ de types normalement bloqué ou normalement passant, soit des transistors bipolaires, selon le type de circuit logique dans lequel la porte à coïncidence de l'invention est mise en œuvre. Cependant, les caractéristiques dynamiques de la porte à coïncidence la font utiliser préférentiellement dans les circuits intégrés rapides, tels que ceux qui sont réalisés sur GaAs ou plus généralement sur matériaux du groupe III–V.

L'invention concerne également les circuits qui mettent en œuvre la porte à coïncidence, notamment des circuits diviseurs de fréquence ou des registres à décalage, ou encore des générateurs de fréquence à fréquence variable.

On appelle porte à coïncidence, ou porte à décision unanime, une porte logique comportant au moins deux entrées qui doivent être activées simultanément par des niveaux logiques pour que la sortie de la porte à coïncidence change d'état. Les portes connues ont des commutations franches et rapides en fonction des signaux logiques appliqués aux entrées.

Par exemple, le document Fr-A 2 410 914 décrit une porte logique à coïncidence comportant notamment deux transistors à effet de champ, montés en parallèle, dont les grilles constituent les deux entrées de la porte à coïncidence. Ces transistors, montés en source commune, sont alimentés sur leurs drains par une unique alimentation comprenant une capacité. C'est la capacité qui fait basculer la sortie de la porte à coïncidence, selon que les deux transistors, bloqués ou passant simultanément, chargent ou déchargent la capacité.

Aussi la porte à coïncidence selon l'invention ne change d'état que si les deux entrées sont activées par de mêmes niveaux logiques (coïncidence). Dans le cas contraire (anti-coïncidence), la porte garde son état antérieur.

Elle comporte deux transistors montés en parallèle, dont les grilles – s'il s'agit de transistors à effet de champ – constituent les entrées de la porte à coïncidence. Chaque transistor a sa source mise à la masse, et est alimenté par son drain à travers une résistance. La particularité de la porte selon l'invention est que les tensions d'alimentation sont différentes pour les deux transistors. Le premier transistor est alimenté à travers une première résistance saturable, de forte valeur, à partir d'une tension + $V_{DD}$. Le second transistor est également alimenté à travers une seconde résistance saturable, identique à la première, mais sa tension d'alimentation est prélevée, à travers une diode Schottky montée dans le sens direct, au point commun entre la première résistance saturable et le drain du premier transistor. La sortie de cette porte à coïncidence est prélevée au point commun entre la diode Schottky et la deuxième résistance saturable, et est appliquée à la grille d'un troisième transistor de charge, de capacité C. En outre, la tension d'alimentation $V_{DD}$ est grande par rapport à la somme $V_H + V_D$, $V_H$ étant la tension au niveau haut en sortie de la porte à coïncidence, et $V_D$ étant la chute de tension à travers la diode à l'état passant.

Ce qui précède peut être traduit en termes de transistors bipolaires en remplaçant la source, la grille et le drain par l'émetteur, la base et le collecteur, respectivement.

De façon plus précise, l'invention telle que revendiquée concerne une porte logique à coïncidence, comportant deux transistors montés en parallèle, dont les sources sont mises à la masse, dont les grilles constituent les entrées de la porte logique, et dont les drains sont reliés, chacun, à une résistance, cette porte logique étant caractérisée, en premier lieu, en ce que les résistances sont des résistances saturables et identiques entre elles, et, en second lieu, en ce que la première résistance saturable et le premier transistor, sont alimentés à partir d'une source de tension fixe, tandis que la seconde résistance saturable et le second transistor sont alimentés à travers une diode Schottky, montée dans le sens passant, à partir du point commun à la première résistance saturable et au drain du premier transistor, le point commun à la diode Schottky et à la seconde résistnace saturable constituant la sortie de la porte logique à coïncidence.

Les caractéristiques de l'invention apparaîtront au cours de la description qui suit et se réfère aux figures annexées, données à titre d'exemple, et qui représentent:

- Figure 1: schéma électrique de la porte à coïncidence selon l'invention, dans une réalisation en logique DCFL,
- Figure 2: courbes d'intensité en fonction de la tension, pour deux résistances saturables, expliquant le fonctionnement de la porte de la figure 1,
- Figures 3 et 4: schémas symboliques de deux diviseurs de fréquence, réalisés avec plusieurs portes selon l'invention,
- Figure 5: schéma électrique de la porte à coïncidence selon l'invention, dans une réalisation en logique BFL.

De façon à simplifier le texte et les figures, l'invention sera exposée en s'appuyant sur des transistors à effet de champ, sans pour autant limiter la portée de l'invention qui s'applique également aux transistors bipolaires.

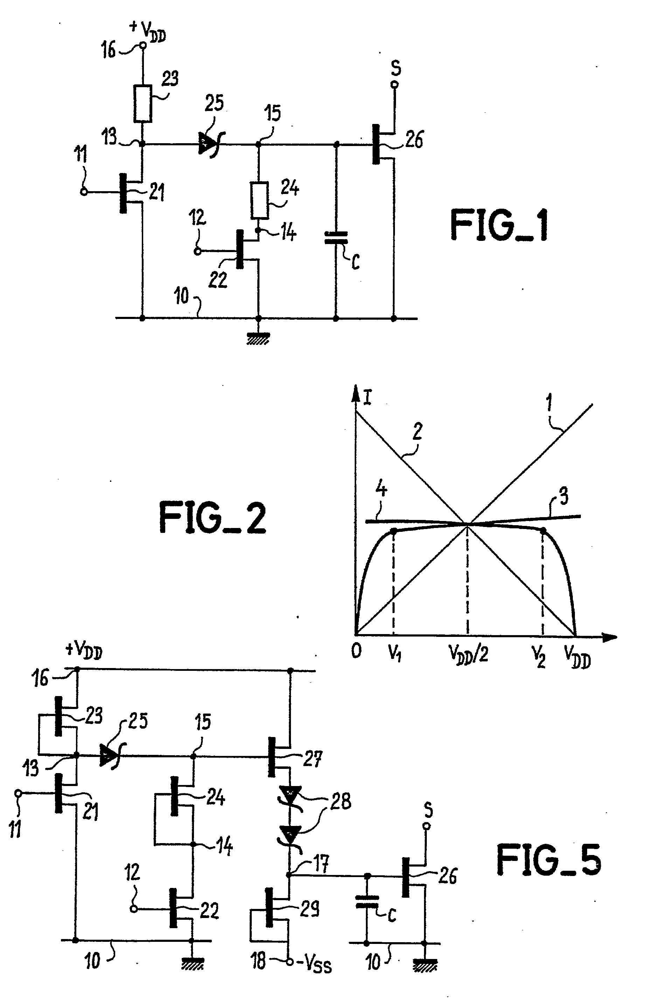

Dans un circuit logique, la commutation est essentiellement un phénomène de charge ou de décharge d'une capacité, équivalente a la capacité de grille d'un transistor et aux capacités associées dans le circuit, et symbolisée par C dans les figures 1 et 5. Les temps de commutation sont de la forme

$$T = \frac{C.\Delta V}{I}$$

dans laquelle:

C = capacité des grilles des transistors du circuit
$\Delta V$ = excursion des tensions logiques
I = courant de charge de la capacité C.

On peut donc agir sur le temps de commutation, ou temps de réponse, d'une porte logique en agissant sur le courant I.

Considérons la porte logique selon l'invention dans une réalisation préférée, représentée en figure 1. Cette figure concerne les transistors à effet de champ de type normalement bloqués, ou "normally-off", à tension de seuil positive, alimentés à partir d'une seul tension +$V_{DD}$ positive par rapport à la masse, ou également les transistors bipolaires.

La porte à coïncidence comporte deux transistors 21 et 22 montés en parallèle, dont les sources sont reliées à la masse 10, et dont les grilles 11 et 12, respectivement, constituent les entrées de la porte à coïncidence. Le premier transistor 21 est alimenté par son drain 13 à travers une première résistance saturable 23, et le second transistor 22 est alimenté par son drain 14 à travers une seconde résistance saturable 24. Mais la première charge saturable 23 est alimentée par une tension 16 positive +$V_{DD}$, tandis que la seconde charge saturable 24 est alimentée, à travers une diode Schottky 25, à partir du point 13 commun à la première charge saturable 23 et au drain du premier transistor 21. La diode Schottky 25 est montée dans le sens direct, passant depuis la première vers la deuxième charge saturable.

La sortie de cette porte est prélevée au point 15, commun à la diode Schottky 25 et à la deuxième charge saturable 24, et est appliquée à un circuit de charge symbolisé par une capacité C et par un transistor 26.

La réalisation de cette porte à coïncidence est dite de type DCFL, c'est-à-dire 'Direct Coupled FET Logic" en anglais, parce que le premier étage, constitué par le transistor 21 et la charge saturable 23, avec sortie au point commun 13 entre les deux, est en soi déjà une porte DCFL.

En outre, pour que cette porte à coïncidence fonctionne bien, il faut que:

- la tension d'alimentation +$V_{DD}$ soit très grande par rapport à la somme de la tension $V_H$ de niveau de sortie au point 15 et de la chute de tension $V_D$ dans la diode 25
$V_{DD} \gg V_H + V_D$
- les deux résistances saturables 23 et 24 soient identiques, et de valeur élevée, et à faible tension de coude.

On appelle résistance ou charge saturable des dispositifs dont la loi de variation du courant de la résistance (ou de l'intensité qui les parcourt) n'est pas linéaire en fonction de la tension appliquée, et ne répond donc pas à la loi d'Ohm V = RI. Des résistances saturables sont par exemple constituées par :

- des transistors à canal creusé, sans grille,
- des transistors dont la grille est reliée à la source,
- des transistors sans grille qui comportent des trous dans l'épaisseur de la couche active.

Le tableau suivant expose les séquences de fonctionnement de la porte à coïncidence de l'invention. Dans ce tableau :

- 1 = niveau logique haut, $V_H$ ou 1 logique,
- 0 = niveau logique bas, ou 0 logique (puisqu'il n'y a qu'une seule tension d'alimentation positive),
- $V_d$ = tension de déchet, ou niveau logique bas, du premier transistor 21 chargé par la résistance 23,
- $V_D$ = chute de tension à travers la diode Schottky 25, à l'état passant,
- T = temps de changement d'état de la porte, lorsque cet état est instable.

| Séquence | 1e grille 11 Entrée | 2e grille 12 Entrée | Tension en 13 | Etat en 15 Sortie | T |
|---|---|---|---|---|---|
| 1 | 1 | 1 | $V_d$ | 0 | |
| 2 | 1 | 0 | $V_d$ | 0 | $\dfrac{C\Delta V}{0}$ |
| 3 | 0 | 0 | $V_H + V_D$ | 1 | |
| 4 | 0 | 1 | $V_H + V_D$ | 1 | $\dfrac{C\Delta V}{I_{24} - I_{23}}$ |
| 5 | 1 | 1 | $V_d$ | 0 | |
| 6 | 0 | 1 | $V_D$ | 0 | $\dfrac{C\Delta V}{I_{23} - I_{24}}$ |
| 7 | 0 | 0 | $V_H + V_D$ | 1 | |
| 8 | 1 | 0 | $V_d$ | 1 | $\dfrac{C\Delta V}{0}$ |
| 9 | 1 | 1 | $V_d$ | 0 | |

Pour la porte à coïncidence de l'invention, les états des séquences impaires sont stables comme ceux d'une porte OU-NON normale, tandis que les états des séquences paires sont plus ou moins instables. En outre, dans cette suite de séquences, il est remarquable qu'il y a un cycle, les séquences 1,5 et 9 étant identiques.

Séquence 1 : les deux transistors sont conducteurs, donc le drain 13 du transistor 21 est à sa tension de déchet $V_d$, mais comme $V_d < V_D$, la diode 25 ne conduit pas et la sortie 15 est à l'état bas 0.

Séquence 2 : le transistor 22 est devenu bloquant, la diode 25 isole bien la sortie, et il n'y a donc pratiquement aucun courant pour charger ou décharger la capacité C. L'état 2 est quasi stable, et la porte ne commute pas. Le temps de commutation $C\Delta V/0$ est infini.

Séquence 3 : les deux transistors 21 et 22 sont bloquants, et le collecteur 13 est amené à une tension $V_H + V_D$, car l'ensemble du transistor de charge 26, de la diode 25 et de la charge saturable 23 agit comme un diviseur de tension, donc la tension en 13 est égale à la tension de niveau haut $V_H$ du transistor 26 plus la chute de tension $V_D$ de la diode 25. La porte commute au niveau 1 logique à sa sortie 15.

Séquence 4 : le transistor 22 devenu conducteur tend à ramener la sortie 15 vers 0, qui est le potentiel de la masse 10, mais la charge saturable 24 limite le courant dans le transistor 22, de telle façon que la commutation devient très lente, avec un temps de commutation :

$$T = \frac{C\Delta V}{I_{24} - I_{23}} \quad \text{et} \quad I_{24} \simeq I_{23}$$

Au cours de cette séquence, le drain 13 reste comme précédemment à la tension $V_H + V_D$. Pour le comprendre, il faut se reporter à la figure 2, qui donne les courbes comparatives d'intensité en fonction de la tension pour deux résistances linéaires et deux résistances saturables. Pour deux résistances linéaires, les courbes 1 et 2 sont des droites qui répondent à la loi d'Ohm, et si la tension diminue, le courant diminue proportionnellement. Par contre, pour deux résistances saturables, le courbes 3 et 4 présentent un coude, et l'intensité n'augmente plus avec la tension après ce coude : il y a saturation. Par conséquent, entre deux tensions repérées arbitrairement $V_1$ et $V_2$, comprises entre 0 et $V_{DD}$, l'intensité reste sensiblement constante quelle que soit la tension. Il a été dit que $V_{DD}$ est très grand devant $V_H$, donc la tension au drain 13 est au delà du coude, et elle reste égale à $V_H + V_D$ comme dans la séquence précédente : la sortie 15 ne commute pas, et est à 1 logique.

Séquence 5 : elle est identique à la première séquence, et la sortie 15 commute à 0 logique.

Séquence 6 : le transistor 21 est bloquant et tend à ramener la sortie 15 vers $V_H$, grâce au courant $I_{23}$ qui traverse la charge saturable 23. Mais comme le transistor 22 est conducteur, le courant $I_{24}$ qui traverse la charge saturable 24 s'oppose à l'effet du courant $I_{23}$. Le temps de changement d'état est:

$$T = \frac{C.\Delta V}{I_{23} - I_{24}} \quad et \quad I_{23} \simeq I_{24}$$

ce temps est très long et la bascule ne commute pas.

Séquence 7 : elle est identique à la deuxième séquence. Les deux transistors étant bloquants, le point 13 remonte à $V_H + V_D$ et la sortie 15 commute sur 1 logique.

Séquence 8 : le transistor 21 est conducteur et ramène le point 13 à sa tension de déchet $V_d$. Le transistor 22 est bloquant et comme la diode Schottky 25 isole bien la capacité C, il n'y a pratiquement aucun courant de charge ou de décharge ; la sortie 15 reste à l'état haut 1 logique, et la porte ne bascule pas. L'état est quasi stable.

Séquence 9 : elle est identique à la première séquence. Un nouveau cycle recommence.

Cette porte logique se comporte une porte OU-NON à coïncidence: il y a changement d'état si les entrées sont identiques. Si les entrées sont différentes, la sortie conserve son état antérieur.

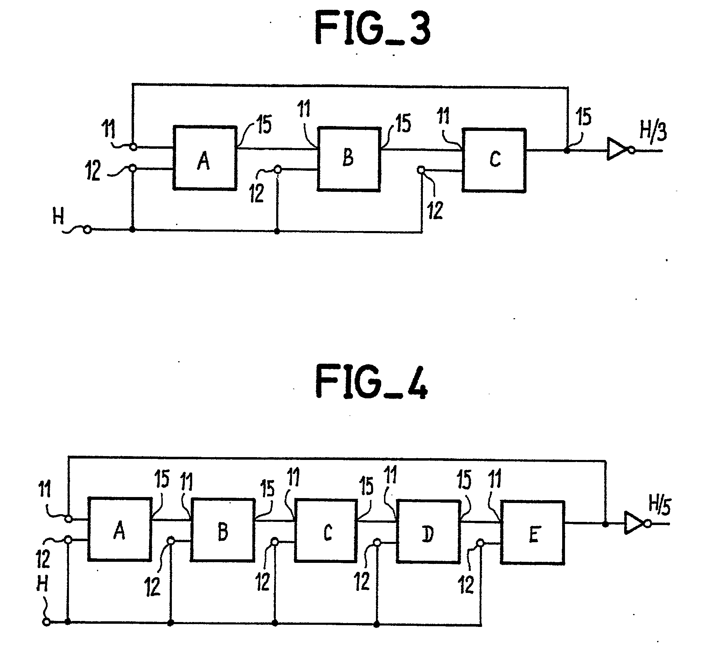

La figure 3 représente un premier exemple d'application de cette porte à coïncidence : c'est un diviseur de fréquence par 3. Il comporte trois portes à coïncidence, en série, représentées sous forme de diagrammes de blocs A, B et C. La sortie 15 d'un étage est connectée à l'entrée 11 du premier transistor 21 de l'étage suivant, et la sortie 15 du dernier étage est rebouclée sur l'entrée 11 du premier étage. Les entrées 12 des seconds transistors 22 de chaque étage sont réunies en une entrée unique du diviseur, sur laquelle est appliquée un signal de fréquence, que l'on peut considérer comme un signal d'horloge H. La sortie du diviseur est prélevée après un inverseur branché sur la sortie 15 du dernier étage: l'inverseur délivre une fréquence H/3.

Le tableau suivant donne les séquences de fonctionnement de ce diviseur par 3. Dans ce tableau, la colonne des états donne l'état d'une porte à coïncidence selon les séquences du précédent tableau: par exemple A6 B4 C1 signifie que la porte A est dans l'état de la séquence 6, la porte B dans l'état de la séquence 4 et la porte C dans l'état de la séquence 1.

| Séquence | H | Entrée de A /Sortie de C | Entrée de B /sortie de A | Entrée de C Sortie de B | Etats de A | B | C |
|----------|---|--------------------------|--------------------------|-------------------------|------------|---|---|
| 1 | 1 | 0 | 0 | 1 | 6 | 4 | 1 |
| 2 | 0 | 0 | 1 | 1 | 3 | 8 | 2 |
| 3 | 1 | 0 | 1 | 0 | 4 | 1 | 6 |
| 4 | 0 | 1 | 1 | 0 | 8 | 2 | 3 |
| 5 | 1 | 1 | 0 | 0 | 1 | 6 | 4 |
| 6 | 0 | 1 | 0 | 1 | 2 | 3 | 8 |
| 7 | 1 | 0 | 0 | 1 | A 6 | B 4 | C 1 |

La séquence 7 ramène à la séquence 1. Ce tableau se comprend aisément en appliquant à chaque porte, pour chaque séquence, la loi imposée par le premier tableau de séquences, et compte tenu de ce que les états impairs sont stables, tandis que les états pairs sont quasi stable. D'après le tableau ci-dessus, la succession des états suit l'ordre 1-2-6-3-4-8 des séquences du premier tableau.

On voit que chaque sortie de porte à coïncidence A, B ou C reste dans le même état pendant 3 pas d'horloge, ou ce qui revient au même pendant 3 séquences; ce circuit est donc un diviseur de fréquence par 3.

La stabilité des états pairs 2, 4 et 6 détermine les limites inférieures de fonctionnement du diviseur. Les limites supérieures des fréquences de fonctionnement sont fixées par les temps de commutation des états impairs, équivalents à ceux d'une porte avec une sortance de 1, c'est-à-dire le temps minimum d'un inverseur logique. Les fréquences limites supérieures de fonctionnement de ces diviseurs dynamiques sont donc très élevées: par exemple, pour un temps minimum de 15 picosecondes, la fréquence limite est supérieure à 30 GHz.

La figure 4 représente un second exemple de diviseur de fréquence utilisant la porte à coïncidence selon l'invention. Il s'agit d'un diviseur de fréquence par 5, mettant en œuvre 5 portes à coïncidence, repérées A, B, C, D, E, montées en série comme celles du précédent diviseur: seule la série est plus longue.

Ce diviseur de fréquence par 5 fonctionne selon le tableau de séquences suivant, qui se lit encore en s'appuyant sur le tableau des séquences relatif à une porte à coïncidence:

| Séquence | H | Entrées de : | | | | | Etats de : | | | | |
|---|---|---|---|---|---|---|---|---|---|---|---|
| | | A | B | C | D | E | A | B | C | D | E |
| 1 | 1 | 0 | 0 | 1 | 0 | 1 | 6 | 4 | 1 | 4 | 1 |
| 2 | 0 | 0 | 1 | 1 | 0 | 1 | 3 | 4 | 2 | 3 | 2 |
| 3 | 1 | 0 | 1 | 0 | 0 | 1 | 4 | 1 | 6 | 4 | 1 |
| 4 | 0 | 0 | 1 | 0 | 1 | 1 | 3 | 2 | 3 | 8 | 2 |
| 5 | 1 | 0 | 1 | 0 | 1 | 0 | 4 | 1 | 4 | 1 | 6 |
| 6 | 0 | 1 | 1 | 0 | 1 | 0 | 8 | 2 | 3 | 2 | 3 |
| 7 | 1 | 1 | 0 | 0 | 1 | 0 | 1 | 6 | 4 | 1 | 4 |
| 8 | 0 | 1 | 0 | 1 | 1 | 0 | 2 | 3 | 8 | 2 | 3 |
| 9 | 1 | 1 | 0 | 1 | 0 | 0 | 1 | 4 | 1 | 6 | 4 |
| 10 | 0 | 1 | 0 | 1 | 0 | 1 | 2 | 3 | 2 | 3 | 8 |
| 11 | 1 | 0 | 0 | 1 | 0 | 1 | 6 | 4 | 1 | 4 | 1 |

Comme dans les tableaux précédents, les états impairs sont stables et les états pairs quasi-stables. On voit que l'état d'une porte ne commute pas pendant cinq séquences, donc ce circuit est un diviseur de fréquence par 5, dont la fréquence maximale est donnée par $1/2T_{min}$, $T_{min}$ étant le temps de commutation minimum d'une porte.

De façon plus générale, la porte à coïncidence selon l'invention permet de réaliser des diviseurs de fréquence d'ordre 2n+1 (impair) avec 2n+1 portes montées en séries selon les figures 3 ou 4.

Cette même figure 4 peut encore fonctionner différemment, en générateur de fréquence à fréquence variable. Il suffit pour cela d'appliquer sur les entrées 12 non plus un signal H en créneaux ou sinusoïdal, mais une tension continue. La porte à coïncidence selon l'invention devient alors un inverseur logique, avec entrée en 11, fonctionnant selon la logique dite LPFL, c'est-à-dire Low Pinch-off Voltage Fet Logic. Le circuit de la figure 4 -ou d'une autre figure comportant un nombre différent impair de portes- est en condition pour osciller, puisqu'on a considéré précédemment qu'il a des états instables, mais appelés quasi-stables en raison de leur temps de commutation très long.

La courbe de réponse -qui n'est pas représentée- d'un tel oscillateur est une courbe gaussienne de la fréquence, lorsque la tension appliquée sur l'entrée 12 passe d'un certain seuil -qui dépend de la technologie des transistors- jusqu'au maximum, égal au 1 logique, pour lequel l'oscillation cesse. Par conséquence, en appliquant sur l'entrée 12 une tension supérieure à la tension de seuil, on peut commander la fréquence d'oscillation de ce circuit, et la faire varier.

La figure 1, et celles qui en découlent, est relative à une porte réalisée avec des transistors normalement bloquants (normally-off) ou bipolaires, alimentés à partir d'une seule source de tension $V_{DD}$.

La figure 5 donne le schéma de cette même porte à coïncidence lorsque les transistors utilisés sont normalement passants (normally-on). Ce circuit est alimenté à partir de deux sources de tensions $+V_{DD}$ et $-V_{SS}$ : il est en logique dite BFL, c'est-a-dire Buffered Fet Logic.

Les transistors normally-on, à tension de seuil négative, sont plus faciles à réaliser que les transistors normally-off, à tension de seuil positive, et ils ont des fréqunces de fonctionnement supérieures, ce qui permet de réaliser des circuits plus rapides. Mais ils consomment plus que les transistors normally-off.

La partie gauche de la figure 5 est en tous points comparable à la figure 1 : seules les charges saturables sont représentées différemment, par des transistors dont la grille est reliée à la source.

La sortie 15 de cette porte à coïncidence est reliée à un décaleur de tension, constitué par un transistor 27, alimenté par +$V_{DD}$, et dont la source est alimentée par une tension négative - $V_{SS}$, à travers deux diodes Schottky 28 et une charge saturable 29. Le point commun 17 à la charge saturable 29 et à la dernière diode Schottky 28 constitue la sortie de ce circuit BFL, chargé par un circuit symbolisé par un transistor 26 et une capacité C.

Un tel décaleur de tension est en soi déjà bien connu : il a pour fonction de fournir des niveaux de sortie négatifs.

Le fonctionnement de cette porte à coïncidence est identique à celui de la porte de la figure 1 : il suffit de remplacer, dans le tableau des séquences, les niveaux 0 par les niveaux logiques bas $V_B$ désignant une tension négative, puisque les transistors sont à tension de seuil négative.

On en tire le tableau suivant:

| Séquence | 1e grille 11 Entrée | 2e grille 12 Entrée | Tension en 15 | Etat en 17 Sortie | T |
|---|---|---|---|---|---|
| 1 | $V_H$ | $V_H$ | 0 | $V_B$ | |
| 2 | $V_H$ | $V_B$ | 0 | $V_B$ | $\dfrac{C'+\Delta V'}{0}$ |
| 3 | $V_B$ | $V_B$ | $V_H+\Delta$ | $V_H$ | |
| 4 | $V_B$ | $V_H$ | $V_H+\Delta$ | $V_H$ | $\dfrac{C'+\Delta V'}{I_{24}-I_{23}}$ |
| 5 | $V_H$ | $V_H$ | 0 | $V_B$ | |
| 6 | $V_B$ | $V_H$ | 0 | $V_B$ | $\dfrac{C'+\Delta V'}{I_{23}-I_{24}}$ |
| 7 | $V_B$ | $V_B$ | $V_H+\Delta$ | $V_H$ | |
| 8 | $V_H$ | $V_B$ | $V_H+\Delta$ | $V_H$ | $\dfrac{C'+\Delta V'}{0}$ |
| 9 | $V_H$ | $V_H$ | 0 | $V_B$ | |

dans lequel:

- $V_H$ = niveau logique haut (1 logique)
- $V_B$ = niveau logique bas (0 logique)
- C' = capacité rapportée en 15
- $\Delta$ = décalage de tension entre 15 et 17
- $\Delta V'$ = $V_H+\Delta$ = excursion de tension du point 15

Cette porte à coïncidence, à transistors normally-on, fonctionne comme la porte à transistors normally-off de la figure 1, et trouve donc les mêmes applications dans des diviseurs de fréquence dynamiques de rang impair 2n+1, ou dans des générateurs de fréquence à fréquence variable.

De façon plus générale, la porte à coïncidence selon l'invention est appliquée en logique rapide, notamment dans les circuits intégrés rapides sur matériaux tels que GaAs ou les composés similaires du groupe III-V.

## Revendications

1. Porte logique à coïncidence, comportant deux transistors (21,22) montés en parallèle, dont les sources mises à la masse (10), dont les grilles (11, 12) constituent les entrées de la porte logique, et dont les drains sont reliés, chacun, à une résistance (23, 24), cette porte logique étant caractérisée, en premier lieu, en ce que les résistances (23, 24) sont des résistances saturables et identiques entre elles, et, en second lieu, en ce que la première résistance saturable (23) et le premier transistor (21), sont alimentés à partir d'une source de tension fixe (16), tandis que la seconde résistance saturable (24) et le second transistor (22) sont alimentés à travers une diode Schottky (25), montée dans le sens passant, à partir, du point (13) commun à la première résistance saturable (23) et au drain du premier transistor (21), le point (15) commun à la diode Schottky (25) et à la seconde résistance saturable (24) constituant la sortie de la porte logique à coïncidence.

2. Porte logique à coïncidence selon la revendication 1, caractérisée en ce que les résistances saturables (23, 24) sont à faible tension de coude.

3. Porte logique à coïncidence selon la revendication 1, caractérisée en ce que les résistances saturables (23, 24) sont constituées par un transistor dont la grille est réunie à la source, ou par un transistor à canal creusé sans métallisation de grille, ou par un transistor sans grille comportant des trous dans la couche active.

4. Porte logique à coïncidence selon la revendication 1, caractérisée en ce que les transistors (21, 22) sont à effet de champ, de type normalement bloqué, à tension de seuil positive.

5. Porte logique à coïncidence selon la revendication 1, caractérisée en ce que les transistors (21, 22) sont à effet de champ, de type normalement conducteur, à tension de seuil négative, la porte comportant, dans ce cas, un étage décaleur de tension constitué par un transistor (27) monté en drain commun, dont la grille est reliée à la sortie (15) de la porte, et dont la source est réunie à une tension négative (18) à travers des diodes (28) de décalage et une résistance saturable (29), le point (17) commun à la dernière diode (28) et à la résistance saturable (29) constituant la sortie de cette porte logique.

6. Porte logique à coïncidence selon la revendication 1, caractérisée en ce que les transistors (21, 22) sont des transistors bipolaires, dont les bases (11, 12) constituent les entrées de la porte.

7. Circuit logique séquentiel, formant diviseur de fréquence d'ordre impair, 2n+1, caractérisé en ce qu'il comporte une pluralité 2n+1 portes logiques selon la revendication 1, montées en série, la sortie (15) d'une porte étant reliée à la première entrée (11) de la porte suivante, la sortie (15) de la dernière porte, qui constitue également la sortie du circuit séquentiel, étant bouclée sur la première entrée (11) de la première porte, et les secondes entrées (12) des portes logiques étant réunies entre elles et constituant l'entrée du circuit séquentiel, sur laquelle est appliquée le signal, dont la fréquence (H) est divisée en sortie par l'ordre 2n+1.

8. Circuit logique séquentiel, formant générateur de fréquence à fréquence variable, caractérisé en ce qu'il est constitué par un circuit logique séquentiel selon la revendication 7, sur l'entrée (12) duquel est appliquée une tension continue, la fréquence en sortie (15) de ce générateur étant fonction de la tension continue appliquée à l'entrée (12).

## Claims

1. A coincidence logic gate comprising two transistors (21, 22) in parallel connection, whose sources are connected to ground (10), whose gates (11, 12) constitute the inputs of the logic gate and whose drains are each connected to a resistor (23, 24) characterized in that firstly, the resistors (23, 24) are saturatable and equal resistors and that secondly, the first saturatable resistor (23) and the first transistor (21) are power-supplied from a fixed voltage source (16), while the second saturatable resistor (24) and the second transistor (22) are power-supplied via a Schottky-diode (25), mounted in the conducting sense, from the common point (13) between the first saturatable resistor (23) and the drain of the first transistor (21), the common point (15) of the Schottky diode (25) and the second saturatable resistor (24) constituting the output of the coincidence logic gate.

2. A coincidence logic gate according to claim 1, characterized in that its saturatable resistors (23, 24) present a low kink voltage.

3. A coincidence logic gate according to claim 1, characterized in that the saturatable resistors (23, 24) are constituted by a transistor whose gate is connected to the source, or by a channel transistor without gate metallisation or by a gateless transistor having holes in the active layer.

4. A coincidence logic gate according to claim 1, characterized in that the transistors (21, 22) are field effect transistors of the normally non-conductive type with the threshold voltage being positive.

5. A coincidence logic gate according to claim 1, characterized in that the transistors (21, 22) are field effect transistors of the normally current-conducting type with the threshold voltage being negative, the logic gate comprising in this case a voltage-shifting stage constituted by a transistor (27) which is arranged in a common drain circuit and whose gate is connected to the output (15) of the logic gate and whose source is connected to a negative voltage (18) through shifting diodes (28) and a saturatable resistor (29), the common point (17) between the last one of these diodes (28) and the saturatable resistor (29) constituting the output of said logic gate.

6. A coincidence logic gate according to claim 1, characterized in that the transistors (21, 22) are bipolar transistors, the bases (11, 12) of which constitute the inputs of the logic gate.

7. A sequential logic circuit acting as a frequence divider of odd order 2n+1, characterized in that it comprises 2n+1 logic gates according to claim 1 which are mounted in series, the output (15) of one logic gate being connected to the first input (11) of the following logic gate, the output (15) of the last logic gate, which also defines the output of the sequential circuit, being looped back to the first input (11) of the first logic gate, and the second inputs (12) of the logic gates being all interconnected and constituting the input of the sequential circuit, to which the signal is applied whose frequency (H) is divided at the output by the number 2n+1.

8. A sequential logic circuit acting as a variable frequency generator, characterized in that it is constituted by a sequential logic circuit according to claim 7, on the input (12) of which a DC-voltage is applied, the output frequency (15) of this generator depending on the DC voltage applied to the input (12).

**Patentansprüche**

1. Logisches Koinzidenz-Glied, das zwei parallel angeordnete Transistoren (21, 22) aufweist, deren Source-Elektroden an Masse (10) liegen, deren Gates (11, 12) die Eingänge des logischen Glieds bilden und deren Drains je mit einem Widerstand (23, 24) verbunden sind, dadurch gekennzeichnet, daß erstens die Widerstände (23, 24) untereinander gleiche sättigbare Widerstände sind und zweitens der erste sättigbare Widerstand (23) und der erste Transistor (21) von einer Fest-Spannungsquelle (16) gespeist werden, während der zweite sättigbare Widerstand (24) und der zweite Transistor (22) über eine in Durchlaßrichtung gepolte Schottky-Diode (25) vom gemeinsamen Punkt (13) des ersten sättigbaren Widerstands (21) und des Drain des ersten Transistors (21) gespeist werden, wobei der gemeinsame Punkt (15) der Schottky-Diode (25) und des zweiten sättigbaren Widerstands (24) den Ausgang des logischen Koinzidenzglieds bildet.

2. Logisches Koinzidenz-Glied nach Anspruch 1, dadurch gekennzeichnet, daß die sättigbarten Widerstände (23, 24) Widerstände mit einer niedrigen Knickspannung sind.

3. Logisches Koinzidenz-Glied nach Anspruch 1, dadurch gekennzeichnet, daß die sättigbaren Widerstände (23, 24) aus einem Transistor, dessen Gate mit der Quelle vereint ist, oder aus einem Kanaltransistor ohne Gatemetallisierung oder aus einem Transistor ohne Gate bestehen, der Löcher in der aktiven Schicht aufweist.

4. Logisches Koinzidenz-Glied nach Anspruch 1, dadurch gekennzeichnet, daß die Transistoren (21, 22) Feldeffekttransistoren sind, die normalerweise blockiert sind und eine positive Schwellenspannung besitzen.

5. Logisches Koinzidenz-Glied nach Anspruch 1, dadurch gekennzeichnet, daß die Transistoren (21, 22) Feldeffekttransistoren sind, die normalerweise leitend sind und eine negative Schwellenspannung besitzen, wobei das Glied in diesem Fall eine Spannungsverschiebe-Stufe aufweist, die aus einem Transistor (27) in Drain-Basisschaltung besteht, dessen Gate mit dem Ausgang (15) des Glieds verbunden ist und dessen Source mit einer negativen Spannung (18) über Verschiebe-Dioden (28) und einen sättigbaren Widerstand (29) verbunden ist, wobei der gemeinsame Punkt (17) der letzten Diode (28) und des sättigbaren Widerstands (29) den Ausgang dieses logischen Glieds bildet.

6. Logisches Koinzidenz-Glied nach Anspruch 1, dadurch gekennzeichnet, daß die Transistoren (21, 22) bipolare Transistoren sind, deren Basiselektroden (11, 12) die Eingänge des Glieds bilden.

7. Logischer sequentieller Kreis, der einen Frequenzteiler ungeradzahliger Ordnung 2n+1 bildet, dadurch gekennzeichnet, daß er 2n+1 logische Glieder gemäß Anspruch 1 enthält, die in Reihe angeordnet sind, wobei der Ausgang (15) eines Glieds mit dem ersten Eingang (11) des folgenden Glieds verbunden ist, wobei der Ausgang (15) des letzten Glieds, der zugleich den Ausgang des sequentiellen Kreises bildet, an den ersten Eingang des ersten Glieds (11) zur Schleife zurückgeschleift ist und die zweiten Eingänge (12) der logischen Glieder untereinander verbunden sind und den Eingang des sequentiellen Kreises bilden, an den das Signal angelegt wird, dessen Frequenz (H) am Ausgang durch die Ordnung 2n+1 geteilt wird.

8. Logischer sequentieller Kreis, der einen Frequenzgenerator mit variabler Frequenz bildet, dadurch gekennzeichnet, daß er aus einem logischen sequentiellen Kreis gemäß Anspruch 7 besteht, an dessen Eingang (12) eine Gleichspannung angelegt ist, wobei die Frequenz am Ausgang (15) dieses Generators eine Funktion der an den Eingang (12) angelegten Gleichspannung ist.

FIG_1

FIG_2

FIG_5

# FIG_3

# FIG_4